# EUROPEAN PATENT SPECIFICATION

(11) **EP 2 451 039 B1**
(45) Date of publication and mention of the grant of the patent: **31.12.2014**
(21) Application number: 09846802.8
(22) Date of filing: 30.06.2009
(51) Int. Cl.: H02H 11/00

(54) **CONNECTION-ERROR DETECTION APPARATUS**
VORRICHTUNG ZUR ERKENNUNG VON FALSCHEN VERBINDUNGEN
DISPOSITIF DE DÉTECTION DE D'ERREUR DE CONNEXION

(43) Date of publication of application: 09.05.2012
(73) Proprietor: Toshiba Carrier Corporation, Tokyo 108-8580 (JP)
(72) Inventor: HORINO, Hirofumi, Shizuoka 416-8521 (JP); KOBAYASHI, Takehiro, Shizuoka 416-8521 (JP)
(74) Representative: Gleiss, Alf-Olav
(86) International application number: PCT/JP2009/061950
(87) International publication number: WO 2011/001509

(56) References cited:
- JP-A- 6 319 293
- JP-A- 10 170 581
- JP-A- 2000 354 324
- US-A- 3 242 383
- US-A- 4 199 798

## Description

### Technical Field

The present invention relates to a connection-error detection apparatus which detects an error in connection to a device connected to an alternating-current power supply of three-phase-four-line type, which is commonly used in countries other than Japan.

### Background Art

There is a an alternating-current power supply of three-phase four-line type which comprises three phase lines L1, L2, and L3 and one neutral line N. The power supply outputs, for example, an alternating current 400V as each of inter-phase voltages between phase lines L1, L2, and L3, and also outputs an alternating current 230V as each of inter-line voltages between phase lines L1, L2, and L3 and the neutral line N.

Phase lines L1, L2, and L3 and neutral line N of the alternating-current power supply of three-phase four-line alternating-current type are connected to a power supply terminal of an electronic apparatus, e.g., an air conditioner. The air conditioner to be connected includes 400V-system loads, such as an inverter and a compressor motor having large power consumption, which are operated at the inter-phase voltages of 400V between phase lines L1, L2, and L3, and 230V-system loads, such as a fan motor and a control circuit, which are connected between one of phase lines L1, L2, and L3 and the neutral line n, and are operated at the inter-line voltages of 230V there between (for example, Patent Literature 1).

Phase lines L1, L2, and L3 of the alternating-current power supply of three-phase four-line type and the power supply terminals of the electronic apparatus are manually connected to each other when the electronic apparatus is installed.

### Citation List

### Patent Literature

Patent Literature 1: Jpn. Pat. Appln. KOKAI Publication No. 6-319293

### Summary of Invention

### Technical Problem

In cases, a connection error occurs at wiring connection between the phase lines and the power supply terminal. As a measure to prevent a connection error, the phase lines and the power supply terminals are painted in colors for distinguishing themselves from one another. Even if colored, a connection error which is caused by an artificial mistake of a service person cannot completely be prevented. Particularly, the alternating-current power supply of three-phase four-line type tends to easily cause a connection error because a greater number of lines compared with alternating-current power supplies of three-phase three-line type and single-phase two-line type.

When a connection error occurs, the inter-phase voltage of 400V is applied to 230V-system loads in the electronic apparatus, and control circuits included in the loads of 230V are broken. As a result, driving of the 400V-system loads becomes uncontrollable.

The invention has been made in consideration of situations as described above, and has an object of providing a connection-error detection apparatus with good safety, which can automatically detect a connection error in connection to an alternating-current power supply of three-phase four-line type.

### Solution to Problem

A connection-error detection apparatus according to the invention, is defined in claim 1. Preferred embodiments are defined in dependent claims.

### Advantageous Effects of Invention

The connection-error detection apparatus according to the invention can automatically detect a connection error in connection to an alternating-current power supply of three-phase four-line type.

### Brief Description of Drawings

FIG. 1 is a block diagram showing a configuration of the first example;
FIG. 2 is a graph showing waveforms of direct-current voltage outputs from a rectification circuit compared between during normal connection and during connection error, according to the first example;
FIG. 3 is another graph showing waveforms of direct-current voltage outputs from a rectification circuit compared between during normal connection and during an open phase, according to the first example;
FIG. 4 is a block diagram showing a configuration of the first embodiment;
FIG. 5 is a graph showing waveforms of direct-current voltage outputs from a rectification circuit compared between during normal connection and during connection error, according to the first embodiment;
FIG. 6 is another graph showing waveforms of direct-current voltage outputs from a rectification circuit compared between during normal connection and during an open phase, according to the first embodiment;
FIG. 7 is a block diagram showing a configuration of the second embodiment;
FIG. 8 is a block diagram showing a configuration of the third embodiment;
FIG. 9 is a block diagram showing a configuration of the fourth embodiment; and
FIG. 10 is a block diagram showing a configuration of the fifth embodiment.

### Best Mode for Carrying Out the Invention

[1] Hereinafter, the first example will be described.

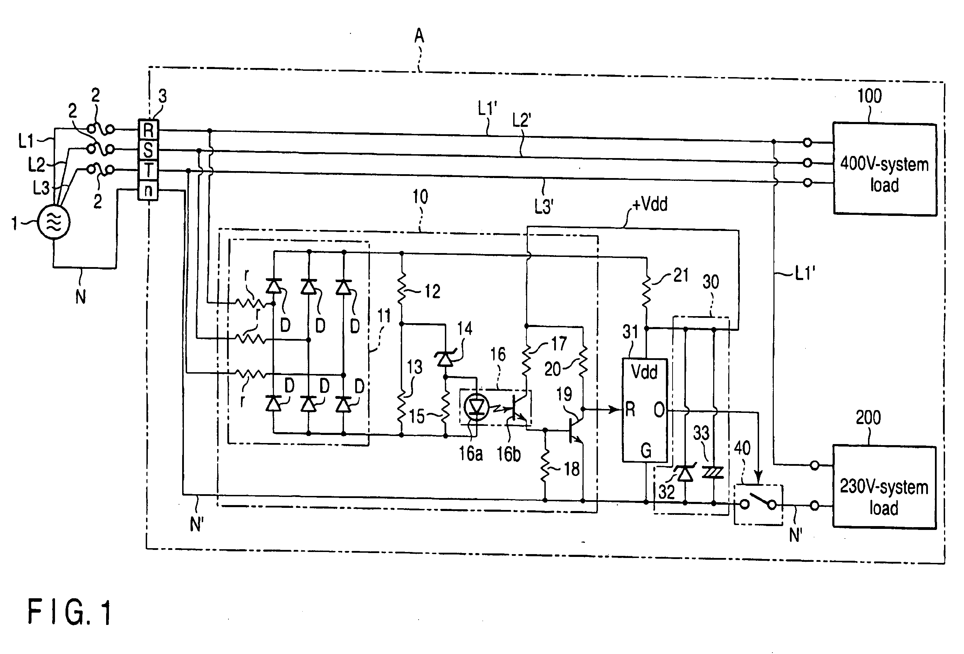

In FIG. 1, 1 denotes an alternating-current power supply of three-phase four-line type which comprises three phase lines L1, L2, and L3 and a neutral line N, and outputs an alternating current of 400V as each of inter-phase voltages between phase lines L1, L2, and L3 one another, and an alternating current of 230V as each of inter-line voltages between phase lines L1, L2, and L3 and the neutral line N.

Power supply terminals 3 of an electronic apparatus (for example, an air conditioner) are respectively wire-connected through fuses 2 to phase lines L1, L2, and L3 and neutral line N of the alternating-current power supply 1 of three-phase four-line type. The Power supply terminals 3 comprises three phase terminals R, S, and T connected to phase lines L1, L2, and L3, and a neutral terminal n connected to the neutral line N. Hereinafter, for explanation, three phase lines and a neutral line inside the electronic apparatus A will be respectively referred to as phase lines L1', L2', and L3' and a neutral line N', in descriptions made below.

The three phase terminals R, S, and T of the power supply terminals 3 are connected to a load 100 of 400V inside the electronic apparatus A through phase lines L1', L2', and L3'. The 400V-system load 100 comprises an inverter and a compressor motor which are operated by the inter-phase voltage (three-phase alternating-current voltage) of 400V. Phase terminal R and neutral terminal n of the power supply terminals 3 are connected to a load 200 of 230V inside the electronic apparatus A through phase line L1' and neutral line N'. The 230V-system load 200 comprises a fan motor and a control circuit which are operated by an inter-line voltage (single-phase alternating-current voltage) 230V. The control circuit performs control of the fan motor operated at 230V and the inverter operated at 400V.

Further, a voltage detection circuit 10 is connected to phase lines L1, L2, and L3 inside the electronic apparatus A.

A voltage detection circuit 10 comprises: a full-wave rectification circuit 11 formed by bridge-connecting nine diodes connected through three input resistors r to phase lines L1', L2', and L3'; a series circuit of resistors 12 and 13, applied with a direct current voltage (DC voltage) which is output from the full-wave rectification circuit 11; a series circuit of a zener diode 14 and a resistor 15, applied with a voltage which is generated at the resistor 13; a light emitting diode 16a applied with a voltage which is generated at the resistor 15; a series circuit of a resistor 17, a phototransistor 16b, and a resistor 18; and an NPN transistor 19 with two ends of the resistor 18 connected between a base and an emitter of the transistor 19. Further, the voltage detection circuit 10 applies a direct current voltage Vdd of 5V which is output from a power supply circuit 30 described later, to a series circuit formed of the resistor 17, phototransistor 16b, and resistor 18, and also applies the direct current voltage Vdd through a resistor 20, to between a collector and the emitter of the transistor 19, thereby to obtain a collector voltage of the transistor 19 as an output. The light emitting diode 16a and phototransistor 16b form a photocoupler 16.

Among constitutional elements of the voltage detection circuit 10 described above, a configuration formed of the resistors 12 to 20 except the full-wave rectification circuit 11 functions as a first determination means which determines whether an output voltage of the full-wave rectification circuit 11 is above a predetermined value Vs or not.

That is, when the output voltage of the full-wave rectification circuit 11 is above the predetermined value Vs, a current flows through the zener diode 14, and the light emitting diode 16a emits light, turning on the phototransistor 16b. When the phototransistor 16b turns on, the transistor 19 also turns on, thereby lowering the collector voltage of the transistor 19 to a low level. Otherwise, when the output voltage of the full-wave rectification circuit 11 is lower than the predetermined value Vs, no current flows through the zener diode 14. The light emitting diode 16a does therefore not emit light, and the phototransistor 16b turns off. When the phototransistor 16b turns off, the transistor 19 also turns off, thereby raising the collector voltage of the transistor 19 to a high level. The collector voltage at the high level is output as a reset signal.

The output voltage of the full-wave rectification circuit 11 is applied through a resistor 21 to each of a timer circuit (second determination means) 31, a zener diode 32, and a condenser 33. An output end (collector of the transistor 19) is connected to a reset terminal (Reset) of a timer circuit 31. A switch 40 described later is connected to an output terminal (Out) of the voltage detection circuit 10. The zener diode 32 and condenser 33 form a power supply circuit 30. An end of each element is connected to an output end of the full-wave rectification circuit 11, and the other end thereof is connected to the neutral line N'. Therefore, a terminal voltage of the condenser 33 is fixed to a zener voltage of the Zener diode 32. Accordingly, the direct current voltage Vdd is generated by the condenser 33 and zener diode 32. The direct current voltage Vdd is an operational power supply for the timer circuit 31. The zener voltage of the zener diode 32 is used as the voltage Vdd of this direct-current power supply, and has an output of about 5V. Therefore, even when a wiring error takes place, a rated output is possible. When a wiring error takes place, a direct current voltage of 400V or more is applied to the condenser 33 and zener diode 32, and therefore, elements having a high rated voltage need to be used. Similarly, each of circuit elements in the voltage detection circuit 10 is applied with a direct current voltage of 400V or more, elements having a high rated voltage need to be used. In general, an IC formed of a semiconductor logic circuit is used as the timer circuit 31 which may alternatively be formed by combining an IC and a resistor with a charge/discharge circuit formed of a condenser.

The timer circuit 31 repeats counting of time t each time a reset signal is received from the voltage detection circuit 10. Before the counted time t reaches a constant time t1, the timer circuit 31 outputs an off signal (zero voltage). When the counted time t reaches the constant time t1 without receiving any reset signal from the voltage detection circuit 10, the timer circuit 31 outputs an on signal at a predetermined voltage. That is, when the timer circuit 31 receives a next reset signal before the counted time t reaches the constant time t1 after receiving a reset signal from the voltage detection circuit 10, the timer circuit 31 then continues outputting the off signal (zero voltage). Here, the constant time t1 is set to about one cycle of the voltage of the alternating-current power supply of the three-phase four-line type.

Further, the switch (first switch) 40 is inserted in and connected to the neutral line N' as a conduction path between the neutral terminal n among the power supply terminals 3 and the 230V-system load 200. The switch 40 is, for example, a relay contact or a semiconductor switch element, which closes upon supply of an on signal from the timer circuit 31, and opens upon supply of an off signal from the timer circuit 31. Therefore, there is a possibility that the 230V-system load 200 is supplied with a direct current voltage of 400V or more. However, the switch 40 opens beforehand, and therefore, no excessive voltage is applied to the 230V-system load 200. Therefore, various devices included in the 230V-system load 200 is protected from breakdown due to any excessive voltage.

Operations will be described next.

### (1) Normal connection

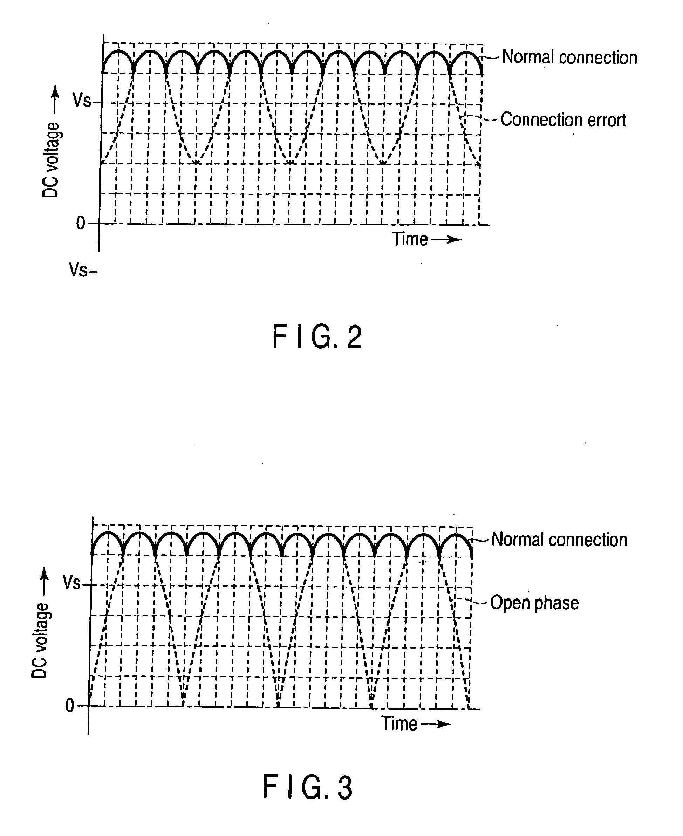

As shown in FIG. 1, when phase lines L1, L2, and L3 and neutral line N of the alternating-current power supply 1 of three-phase four-line type are correctly wire-connected to the power supply terminals 3, an inter-phase voltage of 400V is generated between one another of phase terminals R, S, and T, and an inter-line voltage of 230V is generated between one another of phase terminal R and the neutral terminal n of the power supply terminals 3. Further, the inter-phase voltages of 400V are supplied to the 400V-system load 100. Further, the inter-phase voltages of 400V each are subjected to full-wave rectification by the full-wave rectification circuit 11 of the voltage detection circuit 10. A direct current voltage having a waveform as indicated by a continuous line in FIG. 2 is output from the full-wave rectification circuit 11. This output voltage is higher than the predetermined value Vs. Therefore, the voltage detection circuit 10 does not generate a reset signal.

The timer circuit 31 is supplied with the direct current voltage Vdd as the output voltage is generated from the full-wave rectification circuit 11. The timer circuit 31 then starts operating, and outputs an off signal during a constant time t1. Due to the off signal, the switch 40 is kept open, and no voltage is supplied to the 230V-system load 200.

When the constant time t1 elapses before the voltage detection circuit 10 generates a reset signal, the timer circuit 31 outputs an on signal, based on a determination that connection to the alternating-current power supply 1 of the three-phase four-line type is not an error. The on signal causes the switch 40 to close, and the inter-line voltage of 230V between phase terminal R and the neutral terminal n is supplied to the 230V-system load 200 through phase line L1' and neural line N'. In this manner, the 230V-system load 200 operates, and the 400V-system load 100 is controlled to drive by a control circuit of the 230V-system load 200.

### (2) Connection error

When phase lines L1, L2, and L3 and neutral line N of the alternating-current power supply 1 of three-phase four-line type are not correctly wire-connected to the power supply terminals 3 of the electronic apparatus A, for example, phase line L3 is wire-connected to the neutral terminal n and the neutral line N is wire-connected to phase terminal T, the inter-line voltage of 230V lower than the inter-phase voltage of 400V is generated between phase terminals S and T and between phase terminals R and T, and the inter-phase voltage of 400V higher than the inter-line voltage of 230V is generated between phase terminal R and the neutral terminal n. Therefore, between internal phase lines L2' and L3' and between internal phase lines L1' and L3' in the electronic apparatus A, the inter-line voltage of 230V which is lower than the inter-phase voltage of 400V thereof is generated. Between phase line L1' and the neutral line N', the inter-phase voltage of 400V higher than the inter-line voltage of 230V is generated. Then, 400V between phase terminals R and S, 230V between phase terminals S and T, and 230V between phase terminals R and T are input to the full-wave rectification circuit 11 of the voltage detection circuit 10. As indicated by a broken line in FIG. 2, a direct current voltage having a waveform whose level changes up and down over the predetermined value Vs is output from the full-wave rectification circuit 11. When the output voltage is smaller than the predetermined value Vs, the voltage detection circuit 10 generates the reset signal. The timer circuit 31 outputs the off signal upon receipt of the reset signal from the voltage detection circuit 10, to open or maintain the switch 40 opened.

As shown in FIG. 2, the reset signal is generated once for every 180 degrees (1/4 cycles). Therefore, the timer circuit 31 starts counting the time t each time a reset signal is received from the voltage detection circuit 10. The timer circuit 31 continues outputting the off signal since a next reset signal is received before the counted time t reaches the constant time t1 (substantially equal to one cycle). Accordingly, the switch 40 is maintained opened, and an excessive inter-line voltage of 400V between phase terminal R and the neutral terminal n of the power supply terminals 3 is not supplied to the 230V-system load 200. Accordingly, the control circuit of the 230V-system load 200 is prevented from breakdown.

Thus, when a connection error occurs, the connection error can be detected automatically, and safety can be maintained for the 230V-system load 200.

The circuit described above is configured such that power supplies for the timer circuit 31 and the voltage detection circuit 10 for controlling the switch 40 to turn on and off are all covered by the power supply circuit 30 using the output of the full-wave rectification circuit 11 of the voltage detection circuit 10. Therefore, no separate power supply is required to drive these circuits, and the circuits are simplified accordingly.

### (3) Open phase

Even when phase lines L1, L2, and L3 and neutral line N of the alternating-current power supply 1 of the three-phase four-line type are correctly wire-connected as shown in FIG. 1, any of the fuses 2 of phase lines L1, L2, and L3 may cause fusion cutting due to an excessive current. In this case, two phases of the inter-phase voltages of 400V are lost, i.e., so-called an open phase occurs.

For example, when the fuse 2 on phase line L3 of the alternating-current power supply 1 of three-phase four-line type causes fusion cutting, the power supply line L3' in the electronic apparatus A, which is connected to the power supply terminal T, has an open phase. The inter-phase voltages become zero respectively between phase terminals T and S of the power supply terminals 3 and between phase terminals R and T thereof, i.e., between the power supply lines L3' and L2' in the electronic apparatus A and between the power supply lines L3' and L1'. Then, proper operation of the 400V-system load 100 is impossible any more.

During this open phase occurring, as indicated by a broken line in FIG. 3, the full-wave rectification circuit 11 outputs a direct current voltage having a waveform which greatly changes from a normal operation level to the zero level over the predetermined value Vs. When this output voltage is smaller than the predetermined value Vs, the voltage detection circuit 10 generates a reset signal.

As shown in FIG. 3, substantially like when a connection error occurs, a reset signal is generated once for every 180 degrees (1/4 cycles). Therefore, each time the reset signal is received from the voltage detection circuit 10, the timer circuit 31 starts counting the time t. However, since a next reset signal is received before the counted time t reaches the constant time t1 (one cycle), the timer circuit 31 continues outputting the off signal. Accordingly, the switch 40 remains opened, and electric conduction to the 230V-system load 200 is shut off. Thus, the 230V-system load 200 does not operate any more, and unrequired driving control of the 400V-system load 100 is prevented.

Thus, an open phase can be detected automatically, and improper operation of the 400V-system load 100 and 230V-system load 200 can be prevented.

The predetermined value Vs is set to be lower than the minimum voltage output from the full-wave rectification circuit 11 during normal connection, and is set to be higher than the minimum voltage output from the full-wave rectification circuit 11 during a connection error. During an open phase, an output of the full-wave rectification circuit 11 temporarily goes to zero. However, by selecting a condenser which has a sufficient volume as the condenser 33 forming part of the power supply circuit 30, the power supply circuit 30 can be configured to retain enough power to operate each of circuits which are supplied with power from the power supply circuit 30, even when the output of the full-wave rectification circuit 11 temporarily lowers.

As has been described above, the connection-error detection apparatus according to the present embodiment can detect a wiring error by a simple circuit configuration since an apparatus comprising loads which are operated by a voltage of each of phase lines of an alternating-current power supply of three-phase four-line type comprises: a rectification circuit which is connected to each of the phase lines of the alternating-current power supply of three-phase four-line type; and a determination means (a combination of a first determination means and a second determination means) which determines a connection error in connection to the alternating-current power supply of three-phase four-line type, based on a rectified output of the rectification circuit. Further, an open phase can be detected at the same time.

More specifically, in an apparatus comprising a first load which operates by a voltage of each of phase lines of an alternating-current power supply of a three-phase four-line type, and the second load which operates by a voltage between one of the phase lines and a neutral line of the alternating-current power supply of the three-phase four-line type, the connection-error detection apparatus comprising: a rectification circuit connected to each of the phase lines of the alternating-current power supply of the three-phase four-line type; a first determination means which determines whether an output voltage of the rectification circuit is above a predetermined value or not, and generates a reset signal if a determination result indicative of being smaller than the predetermined value; a timer means which operates by the output voltage of the rectification circuit, repeats counting time each time the first determination means generates the reset signal, outputs an off signal till the counted time reaches a constant time, and outputs an on signal when the counted time reaches the constant time before the first determination means generates the reset signal; and a switch which is inserted in and connected to a conduction path between a neutral line N' of a power supply terminal and the second load, closes in response to the on signal from the timer means, and opens in response to the off signal. Accordingly, the second load can be prevented from breakdown during a connection error.
[2] The first embodiment of the invention will now be described.

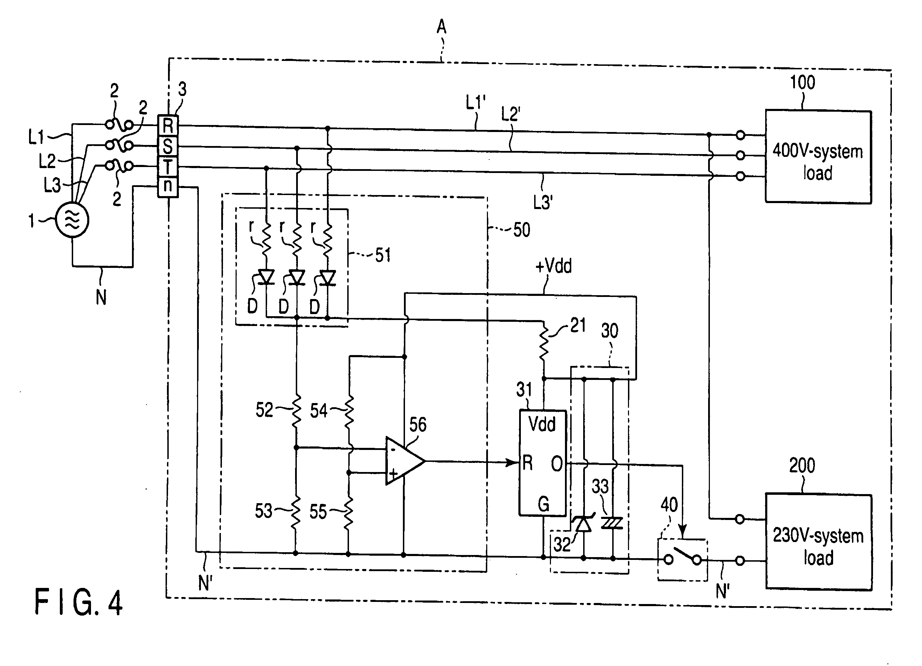

As shown in FIG. 4, a voltage detection circuit 50 is connected to phase lines L1', L2', and L3' in an electronic apparatus A. The voltage detection circuit 50 comprises: a half-wave rectification circuit 51 formed by bridge-connecting three input resistors r and three diodes D; a series circuit formed of resistors 52 and 53 which are applied with a direct-current (DC) voltage output from the half-wave rectification circuit 51; a series circuit formed of resistors 54 and 55 applied with a direct current voltage of 5V generated from an output voltage of the half-wave rectification circuit 51; and a comparison circuit 56 which compares a reference voltage generated at the resistor 55 with a voltage generated at the resistor 53. Through comparison by the comparison circuit, whether the output voltage of the half-wave rectification circuit 51 is above a predetermined value Vs or not is determined.

That is, when the output voltage of the half-wave rectification circuit 51 is above the predetermined value Vs, an output voltage of the comparison circuit 56 is a low level. When the output voltage of the half-wave rectification circuit 51 is lower than the predetermined value Vs, the output voltage of the comparison circuit 56 is a high level. A collector voltage at the high level is supplied as a reset signal for a timer circuit 31.

Thus, when the half-wave rectification circuit 51 is used, a direct-current output voltage thereof is half of that when a full-wave rectification circuit is used. Therefore, even when a connection error occurs, a voltage applied to each of circuit elements in a power supply circuit 30 and a voltage detection circuit 10 is so low that inexpensive elements which have a low rated voltage can be employed.

Other configurations are the same as those in the first example; and descriptions thereof will be omitted herefrom.

### Operations will now be described

### (1) Normal connection

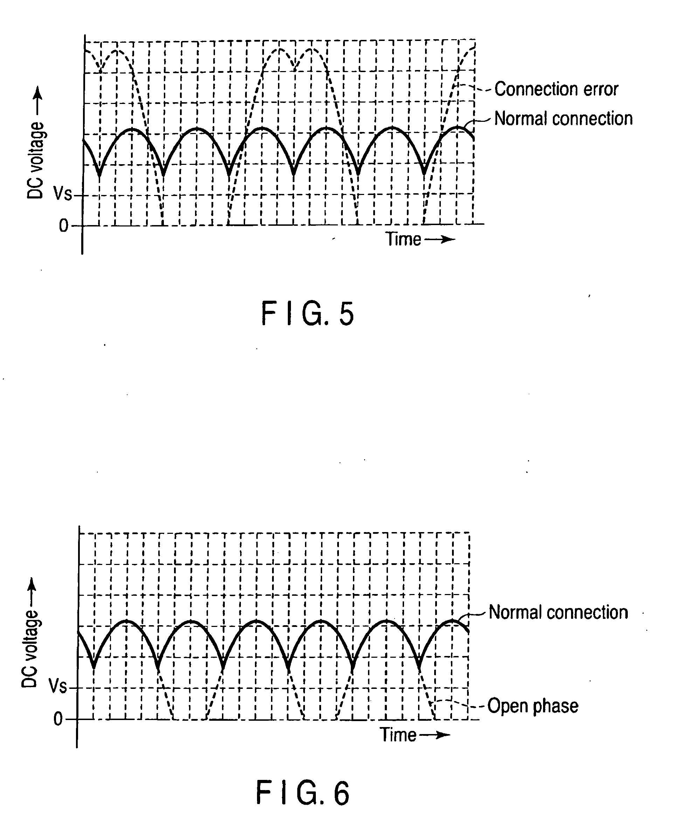

Alternating currents of inter-phase voltages of 400V which are generated at internal phase lines L1', L2', and L3' of the electronic apparatus A through phase terminals R, S, and T of power supply terminals 3 are subjected to half-wave rectification by the half-wave rectification circuit 51. A direct current voltage having a waveform as indicated by a continuous line in FIG. 5 is output from the half-wave rectification circuit 51. This output voltage is higher than the predetermined value Vs. Therefore, the voltage detection circuit 50 does not generate a reset signal.

As the output voltage of the half-wave rectification circuit 51 is above a set value Vₛ, the timer circuit 31 starts operation of counting time, and outputs an off signal for a constant time t1. This off signal maintains the switch 40 opened, and 230V-system load 200 is therefore not supplied with any voltage.

If the constant time t1 elapses before the voltage detection circuit 50 generates a reset signal, the timer circuit 31 outputs an on signal, based on a determination that connection to the alternating-current power supply 1 of three-phase four-line type is not an error. This on signal causes the switch 40 to close, and an inter-line voltage of 230V between phase terminal R and neutral terminal n of the power supply terminals 3 is supplied to the 230V-system load 200. Accordingly, the 230V-system load 200 operates, and a 400V-system load 100 is controlled to drive by a control circuit of the 230V-system load 200.

### (2) Connection error

For example, phase line L3 is wired-connected to the neutral terminal n and the neutral line N is wire-connected to phase terminal T, alternating currents of an inter-line voltage of 230V lower than an inter-phase voltage of 400V are generated between phase terminals S and T and between phase terminals R and T, and an alternating current of the inter-phase voltage of 400V higher than the inter-line voltage of 230V is generated between phase terminal R and the neutral terminal n.

In the electronic apparatus A, an alternating current of 400V between phase lines L1' and L2', an alternating current of 230V between phase lines L3' and L2', and an alternating current of 230V between phase lines L3' and L1' are input to the half-wave rectification circuit 51 of the voltage detection circuit 50. As indicated by a broken line in FIG. 5, the half-wave rectification circuit 51 outputs a direct current voltage having a waveform which changes to the zero level over a normal operation level and the predetermined value Vs. When this output voltage is lower than the predetermined value Vs, the voltage detection circuit 50 outputs a reset signal.

Each time a reset signal from the voltage detection circuit 50 is received, the timer circuit 31 is reset and continues outputting an off signal. This off signal causes the switch 40 to open, and the 230V-system load 200 is therefore not supplied with any alternating current of an excessive inter-phase voltage of 400V. Therefore, the 230V-system load 200 is prevented from breakdown.

### (3) Open phase

When a fuse 2 of phase line L1 causes fusion cutting and the R terminal therefore has an open phase, each of inter-phase voltages between phase terminals R and S and between phase terminals R and T of the power supply terminals 3 becomes zero, which hinders the 400V-system load 100 from operating properly.

During this open phase, a direct current voltage having a waveform which changes from a normal operation level to the zero level as indicated by a broken line in FIG. 6 is output from the half-wave rectification circuit 51. When this output voltage is lower than the predetermined value Vs, the voltage detection circuit 50 generates a reset signal.

The timer circuit 31 receives the reset signal from the voltage detection circuit 10, and outputs an off signal to open the switch 40. Since the voltage detection circuit 10 mandatorily outputs the reset signal at least once in a cycle of the alternating-current power supply, the timer circuit 31 maintains the switch 40 opened. As a result, conduction to the 230V-system load 200 is shut off. Since the 230V-system load 200 thus does not operate, unrequired drive control of the 400V-system load 100 can be prevented.

Since the present embodiment uses the half-wave rectification circuit 51, a period equivalent to 120 electrical degrees for which the output of the half-wave rectification circuit 51 is "0V" appears when a connection error occurs, as shown in FIG. 5. A period equivalent to 60 electrical degrees for which the output is "0V" appears when an open phase occurs. Therefore, a reference voltage used to determine normal or abnormal (connection error or open phase) can be set to a low value, and power consumption of circuits for generating the reference voltage Vs can be reduced.

In this case, however, the period for which the output from the half-wave rectification circuit 51 is "0V" is long. Therefore, a volume of the condenser 33 forming part of the power supply circuit 30 needs to be increased in comparison with a case of using a full-wave rectification circuit 11 in the first embodiment.
[3] The second embodiment of the invention will now be described.

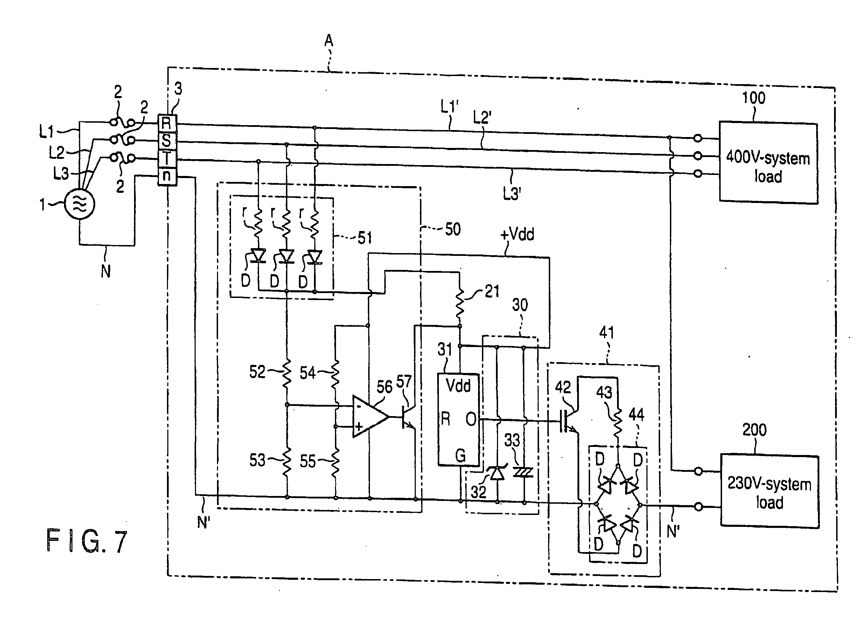

As shown in FIG. 7, in a voltage detection circuit 50, a base of an NPN transistor 57 is connected to an output end of the comparison circuit 56, and a collector and an emitter of the transistor 57 are connected in parallel to power supply terminals of a timer circuit 31. Accordingly, an input from the voltage detection circuit 50 to a reset terminal is removed. A direct current voltage Vdd of a power supply circuit 30 is used for a power supply to the comparison circuit 56.

Further, a switch circuit 41 is used in place of the switch 40 in the first and second embodiments. The switch circuit 41 comprises a switch element 42, a resistor 43, and a diode bridge 44 according to a full-wave rectification method, which comprises four diodes D. An FET or IGBT capable of controlling conduction of a relatively large current by using a very small current is used as a switch element 42. By employing an FET or IGBT which can be operated to turn on/off by a very small current, power consumption of these elements is reduced, and a current capacity of the direct current voltage Vdd for driving elements can be reduced.

During normal connection, an output voltage of the half-wave rectification circuit 51 is above a predetermined value Vs. Therefore, the output voltage of the comparison circuit 56 is of a low level, and the transistor 57 maintains an off state. In this manner, an operation voltage Vdd is applied to the timer circuit 31, and the timer circuit 31 operates and outputs an on signal upon elapse of a constant time t1. This on signal causes the switch element 42 to turn on, and a neutral line N' is made conductive through the switch element 42, resistor 43, and two diodes D of the diode bridge 44.

During a connection error, the half-wave rectification circuit 51 outputs a direct current voltage having a waveform which changes to the zero level over a normal operation level and the predetermined value Vs, as indicated by a broken line in FIG. 5. When the output voltage is lower than the predetermined value Vs, the output voltage of the comparison circuit 56 is high level, and the transistor 57 is on. When the transistor 57 is turned on, the operation voltage Vdd for the timer circuit 31 is removed by a bypass through the transistor 57, and the timer circuit 31 is made inoperative (off). Therefore, the timer circuit 31 outputs an off signal, and the switch element 42 is turned off. Therefore, the switch element 42 maintains the off state, and the neutral line N' remains in a non-conductive state. Also during an open phase, the timer circuit 31 is made inoperative, the switch element 42 maintains the off state, and the neutral line N' is made non-conductive.

Other configurations and operation are the same as those of the first and second embodiments. Therefore, descriptions thereof will be omitted.

When loads do not use alternating currents but require direct currents, the diode bridge 44 may be of a half-wave rectification method.
[4] The third embodiment of the invention will now be described.

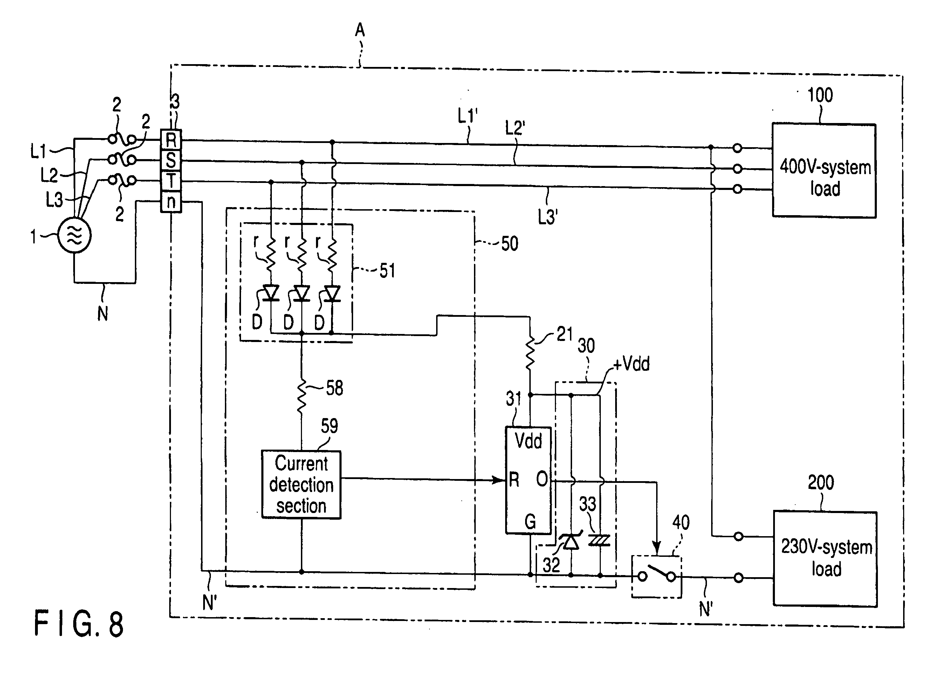

As shown in FIG. 8, a voltage detection circuit 50 comprises a half-wave rectification circuit 51, a resistor, and a current detection section 59. An output voltage of the half-wave rectification circuit 51 is applied to the current detection section 59 through the resistor 58, and a reset signal as an output from the current detection section 59 is supplied to a timer circuit 31. The current detection section 59 generates the reset signal when a current based on the output voltage of the half-wave rectification circuit 51 is smaller than a set value.

During normal connection, the output voltage of the half-wave rectification circuit 51 is above a predetermined value Vs. Therefore, a current flowing through a current detection section 59 is above the set value, and the current detection section 59 does therefore not generate a reset signal. Accordingly, the timer circuit 31 outputs an on signal, and a switch 40 turns on.

During a connection error and an open phase, a current which flows through the current detection section 59 is smaller than the set value when the output voltage of the half-wave rectification circuit 51 is lower than the predetermined value Vs. The current detection section 59 outputs a reset signal. Therefore, the timer circuit 31 outputs an off signal, and the switch 40 turns off.

Other configurations and operations are the same as those of the first and second embodiments. Therefore, descriptions thereof will be omitted.
[5] The fourth embodiment of the invention will now be described.

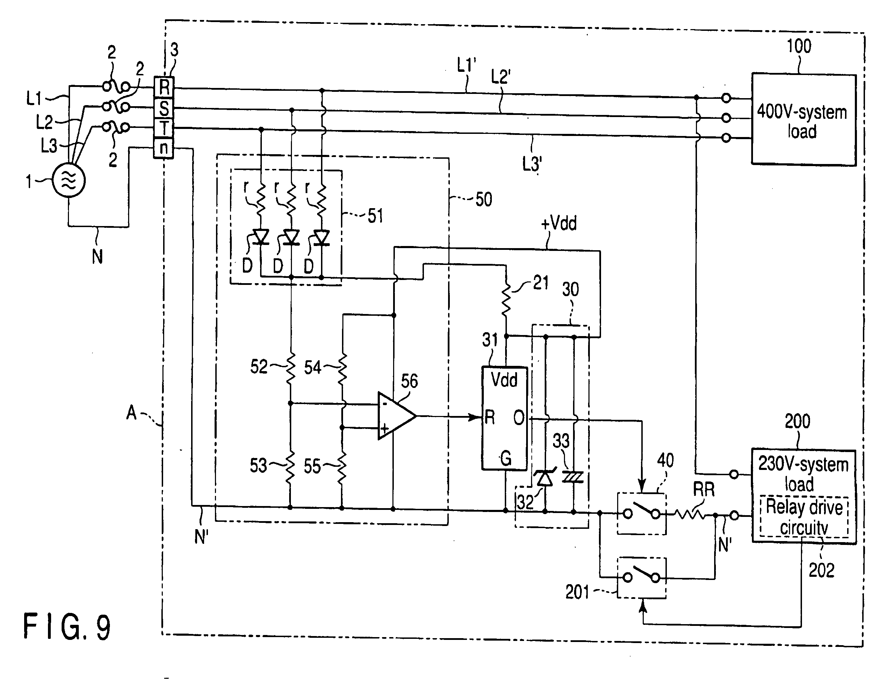

As shown in FIG. 9, a relay contact 201 is connected as a second switch in parallel with the switch 40. Further, a current limit resistor RR is connected in series on a line between the switch 40 and a 230V-system load 200. A relay drive circuit 202 is provided for the 230V-system load 200. The relay drive circuit 202 is operated by conduction to the 230V-system load 200, and closes thereby the relay contact 201. When no conduction is made to the 230V-system load 200, the relay drive circuit 202 stops operating, and opens the relay contact 201.

During normal connection, the timer circuit 31 outputs an on signal, and the switch 40 turns on. When the switch 40 turns on, an alternating current of 230V is supplied to the current limit resistor RR. Then, the control circuit in the 230V-system load 200 starts operating first, and makes the relay drive circuit 202 to operate. The relay contact 201 then closes. Subsequently, the control circuit in the 230V-system load 200 turns on first an electric component, such as a fan motor, whose power consumption is large in the 230V-system load 200. As a result, electric conduction is made to the whole 230V-system load 200 through a parallel circuit parallel to the relay contact 201. At this time, a current flows through the 230V-system load 200 through the switch 40 and the current limit resistor RR. However, since the current limit resistor exists in the middle, most of the current flows through the relay contact 201.

By employing a configuration as described above, no large current flows through the switch 40. Therefore, a switch 40, which has a small size and consumes a small amount of current during driving, can be employed. Accordingly, a direct current voltage Vdd for driving the switch 40 can be reduced, and a capacity of the condenser 33 of the power supply circuit 30 can be reduced.

Other configurations and operations are the same as those of the first and second embodiments. Therefore, descriptions thereof will be omitted.
[6] The fifth embodiment of the invention will now be described.

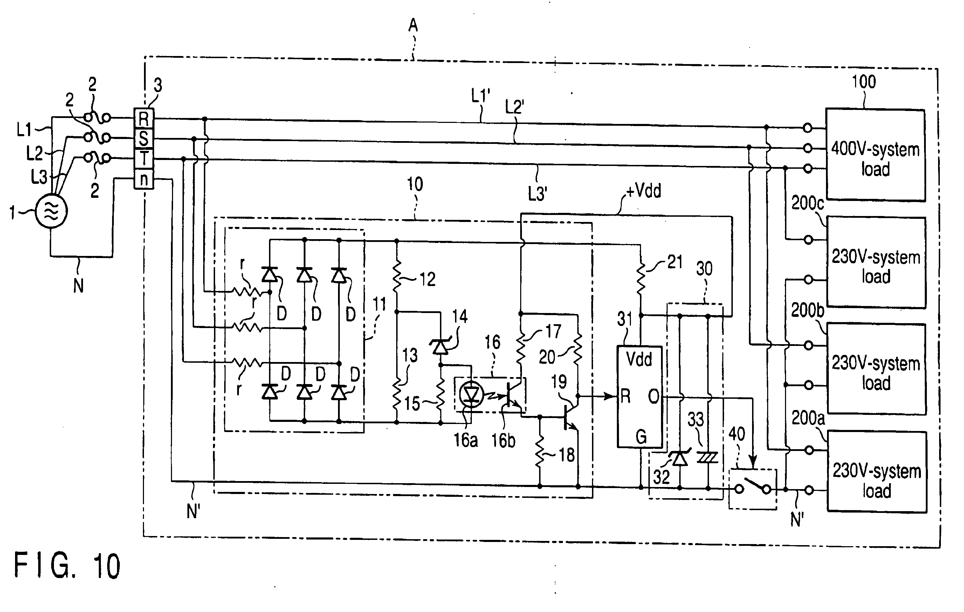

As shown in FIG. 10, according to the present embodiment, there is a case of providing an electronic apparatus A comprising a plurality of 230V-system loads 200, and connection suitable for this case is provided, e.g., a plurality of fans as 230V-system loads 200 are provided in an outdoor unit of an air conditioner. The electronic apparatus A in the figure internally comprises three 230V-system loads 200a, 200b, and 200c. The 230V-system loads 200a, 200b, and 200c as one ends of power supply paths are respectively connected to phase lines L1', L2', and L3' in the apparatus A. The other ends of the power supply paths are connected to an identical neutral line N' through the switch 40. Other configurations and operations are the same as those of the first embodiment. Therefore, descriptions thereof will be omitted herefrom.

By connection as described above, consumption currents of the 230V-system loads 200a, 200b, and 200c are distributed to phase lines L1, L2, and L3. Therefore, a large current can be prevented from flowing through any particular phase line, and harmonics which are generated from the 230V-system loads 200a, 200b, and 200c can be distributed to the phase lines and thereby reduced.

Further, since all the 230V-system loads 200a, 200b, and 200c are commonly connected to the neutral line N' through the switch 40, the switch 40 is opened at the time of a connection error or an open phase, as in the first embodiment. Operations of the 230V-system loads 200a, 200b, and 200c can accordingly be stopped all at once, with a simple configuration.

In the present fifth embodiment, a detection/protection circuit for a connection error or an open phase is the same as that in the first example. As an alternative, a circuit according to any of the first to fourth embodiments can be employed.

As has been described above, a connection-error detection apparatus in an apparatus comprising a first load which is operated by voltages of respective phase lines of an alternating-current power supply of three-phase four-line type, and a second load which is operated by voltages between one of the respective phase lines and a neutral line of the alternating-current power supply of the three-phase four-line type, wherein the connection-error detection apparatus comprises: a rectification circuit connected to each of the phase lines of the alternating-current power supply of the three-phase four-line type; a first determination means which determines whether an output voltage of the rectification circuit is above a predetermined value or not; and a second determination means which determines connection to the alternating-current power supply of the three-phase four-line type to be not an error if a determination result of the first determination means continuously indicates being above the predetermined value for a constant time, or determines the connection to the alternating-current power supply of the three-phase four-line type to be an error if the determination result of the first determination means does not continuously indicate being above the predetermined value for the constant time.

In addition, the rectification circuit may employ either a full-wave rectification circuit or a half-wave rectification circuit. Further, a connection error and the second load can be protected by comprising a switch which is inserted in a conduction path between a neutral line N' of a power terminal and the second load, closes when the determination result of the second determination means is not an error, and opens when the result is an error.

### Industrial Applicability

Safe operations of various apparatuses which use an alternating-current power supply of three-phase four-line type can be achieved.

1... Alternating-current power supply of three-phase four-line type, 2... Fuse, 3... Power supply terminal, L1, L2, L3... Phase line, N... Neutral line, L1', L2', L3'... Phase line in electronic apparatus, N'... Neutral line in electronic apparatus, 10... Voltage detection circuit (first determination means), 11... Full-wave rectification circuit, 16... Photocoupler, 19... NPN transistor, 31... Timer circuit (second determination means), 40... Switch, 100... 400V-system load, 200... 230V-system load, A... Electronic apparatus (air conditioner)

## Claims

1. A connection-error detection apparatus of a structure which includes a first load which operates by a voltage of each of phase lines of an alternating-current power supply (1) of a three-phase four-line type, and a second load which operates by a voltage between one of the phase lines and a neutral line of the alternating-current power supply of three-phase four-line type, the connection-error detection apparatus comprising:
a half-wave rectification circuit (51) connected to each of the phase lines of the alternating-current power supply of the three-phase four-line type;
a first determination means (56) which determines whether an output voltage of the half-wave rectification circuit is above a predetermined value or not;
a second determination means (31) which determines connection to the alternating-current power supply of three-phase four-line type to be not an error if a determination result of the first determination means continuously indicates, for a constant time, a state of being above the predetermined value, or determines the connection to the alternating-current power supply of three-phase four-line type to be an error if the determination result of the first determination means does not continuously indicates, for the constant time, the state of being above the predetermined value.

2. The error connection detection apparatus of claim 1, further comprising a switch (40; 41) which is inserted in and connected to a conduction path between the neutral line and the second load, and closes if a determination result of the second determination means does not indicate an error, or opens if the determination result of the second determination means indicates an error.

3. The connection-error detection apparatus of claim 1, wherein
the first determination means (56) determines whether the output voltage of the half-wave rectification circuit is above the predetermined value or not, and generates a reset signal if a determination result thereof indicates being not above the predetermined value; and
the second determination means (31) is a timer means which operates by an output voltage of the rectification circuit, repeats counting time each time the first determination means generates the reset signal, outputs an off signal till the counted time reaches a constant time, and outputs an on signal when the counted time reaches the constant time before the first determination means generates the reset signal; and further comprising
a switch (40, 41) which is inserted in and connected to a conduction path between the neutral line N and the second load, closes in response to the on signal from the timer means, and opens in response to the off signal.

4. The error connection detection apparatus of claim 3, wherein the first determination means (56), the timer means (31) and the switch (40; 41) use a rectified output of the rectification circuit as a power supply.

## Patentansprüche

1. Vorrichtung zur Erkennung von Anschlussfehlern, mit einem Aufbau, der eine erste Last, die mit einer Spannung einer jeden der Phasenleitungen einer Wechselstromversorgung (1) vom Dreiphasen-Vierleitungs-Typ betrieben wird, und eine zweite Last, die mit einer Spannung zwischen einer der Phasenleitungen und einer Neutralleitung der Wechselstromversorgung vom Dreiphasen-Vierleitungs-Typ betrieben wird, umfasst, wobei die Vorrichtung zur Erkennung von Anschlussfehlern umfasst:
eine Halbwellen-Gleichrichterschaltung (51), die an jede der Phasenleitungen der Wechselstromversorgung vom Dreiphasen-Vierleitungs-Typ angeschlossen ist;
ein erstes Mittel (56) zur Bestimmung, welches bestimmt, ob eine Ausgangsspannung der Halbwellen-Gleichrichterschaltung über einem zuvor festgelegten Wert liegt oder nicht;
ein zweites Mittel (31) zur Bestimmung, welches bestimmt, dass der Anschluss an die Wechselstromversorgung vom Dreiphasen-Vierleitungs-Typ nicht fehlerhaft ist, wenn ein Bestimmungsergebnis des ersten Mittels zur Bestimmung über eine konstante Dauer ständig einen Zustand über dem zuvor festgelegten Wert anzeigt, oder bestimmt, dass der Anschluss an die Wechselstromversorgung vom Dreiphasen-Vierleitungs-Typ fehlerhaft ist, wenn das Bestimmungsergebnis des ersten Mittels zur Bestimmung nicht über die konstante Dauer ständig einen Zustand über dem zuvor festgelegten Wert anzeigt.

2. Vorrichtung zur Erkennung von Anschlussfehlern nach Anspruch 1, des Weiteren umfassend einen Schalter (40; 41), welcher in einen Leitungsweg zwischen der Neutralleitung und der zweiten Last eingefügt und an diesen angeschlossen ist, und schließt, wenn ein Bestimmungsergebnis des zweiten Mittels zur Bestimmung keinen Fehler anzeigt, oder öffnet, wenn das Bestimmungsergebnis des zweiten Mittels zur Bestimmung einen Fehler anzeigt.

3. Vorrichtung zur Erkennung von Anschlussfehlern nach Anspruch 1, wobei
das erste Mittel (56) zur Bestimmung bestimmt, ob die Ausgangsspannung der Halbwellen-Gleichrichterschaltung über dem zuvor festgelegten Wert liegt oder nicht, und ein Rücksetzsignal erzeugt, wenn ein Bestimmungsergebnis derselben anzeigt, dass der Wert nicht über dem zuvor festgelegten Wert liegt; und
das zweite Mittel (31) zur Bestimmung ein Mittel zur Zeitnehmung ist, welches mit einer Ausgangsspannung der Gleichrichterschaltung betrieben wird, die Zeitnehmung jedes Mal wiederholt, wenn das erste Mittel zur Bestimmung das Rücksetzsignal erzeugt, ein Aus-Signal ausgibt, bis die gezählte Zeit eine konstante Zeit erreicht, und ein Ein-Signal ausgibt, wenn die gezählte Zeit die konstante Zeit erreicht, bevor das erste Mittel zur Bestimmung das Rücksetzsignal erzeugt, und des Weiteren umfassend
einen Schalter (40; 41), welcher in einen Leitungsweg zwischen der Neutralleitung N und der zweiten Last eingefügt und an diesen angeschlossen ist, in Reaktion auf das Ein-Signal von dem Mittel zur Zeitnehmung schließt, und in Reaktion auf das Aus-Signal öffnet.

4. Vorrichtung zur Erkennung von Anschlussfehlern nach Anspruch 3, wobei das erste Mittel (56) zur Bestimmung, das Mittel (31) zur Zeitnehmung und der Schalter (40; 41) einen gleichgerichteten Ausgang der Gleichrichterschaltung als Stromversorgung nutzen.

## Revendications

1. Dispositif de détection de connexion d'erreur avec une structure qui comprend une première charge qui fonctionne par une tension de chaque ligne de phase d'une source d'alimentation en courant alternatif (1) de type triphasé à quatre lignes, et une seconde charge qui fonctionne par une tension entre une des lignes de phase et une ligne neutre de la source d'alimentation en courant alternatif de type triphasé à quatre lignes, le dispositif de détection de connexion d'erreur comprenant :
un circuit en redresseur demi-onde (51) qui est relié à chaque ligne de phase de la source d'alimentation en courant alternatif de type triphasé à quatre lignes ;
un premier moyen de détermination (56) qui détermine si une tension de sortie du circuit en redresseur demi-onde est supérieure à une valeur prédéterminée ou non ;
un second moyen de détermination (31) qui détermine que la connexion à la source d'alimentation en courant alternatif de type triphasé à quatre lignes n'est pas en erreur, si un résultat de détermination du premier moyen de détermination indique constamment pour un temps constant, un état au-dessus du valeur prédéterminée, ou détermine que la connexion à la source d'alimentation en courant alternatif de type triphasé à quatre lignes est en erreur, si le résultat de détermination du premier moyen de détermination n'indique pas constamment pour le temps constant l'état au-dessus du valeur prédéterminée.

2. Dispositif de détection de connexion d'erreur selon la revendication 1, en outre comprenant un commutateur (40 ; 41) qui est inséré dans et raccordé à un chemin de conduction entre la ligne neutre et la seconde charge, et se ferme si un résultat de détermination du second moyen de détermination n'indique pas une erreur, ou s'ouvre si le résultat de détermination du second moyen de détermination indique une erreur.

3. Dispositif de détection de connexion d'erreur selon la revendication 1, dans lequel
le premier moyen de détermination (56) détermine si la tension de sortie du circuit en redresseur demi-onde est supérieure à la valeur prédéterminée ou non, et génère un signal de remise à l'état initial si un résultat de détermination de celui-ci indique que la valeur n'est pas supérieur à la valeur prédéterminée ; et
le second moyen de détermination (31) est un moyen de minuterie qui fonctionne par une tension de sortie du circuit en redresseur, répète le comptage de temps à chaque fois que le premier moyen de détermination génère le signal de remise à l'état initial, émet un signal d'arrêt jusqu'à ce que le temps compté atteint un temps constant, et émet une signal marche lorsque le temps compté atteint le temps constant avant que le premier moyen de détermination génère le signal de remise à l'état initial ; et en outre comprenant
un commutateur (40 ; 41) qui est inséré dans et raccordé à un chemin de conduction entre la ligne neutre N et la seconde charge, se ferme en réponse au signal marche provenant du moyen de minuterie, et s'ouvre en réponse au signal d'arrêt.

4. Dispositif de détection de connexion d'erreur selon la revendication 3, dans lequel le premier moyen de détermination (56), le moyen de minuterie (31) et le commutateur (40 ; 41) utilisent une sortie redressé du circuit de redressage en tant que source d'alimentation.
